# EUROPEAN PATENT APPLICATION

(11) **EP 1 197 583 A1**
(43) Date of publication of application: **17.04.2002**
(21) Application number: 01308667.3
(22) Date of filing: 11.10.2001
(51) Int. Cl.: C23C 16/44

(54) **Vapor-coating system including coating container with control of vapor-source activity**

(30) Priority: 13.10.2000 US 687423
(71) Applicant: GENERAL ELECTRIC COMPANY, Schenectady, NY 12345 (US)
(72) Inventor: Worthing, Richard Roy, Jr., Cincinnati, Ohio 45240 (US); Das, Nripendra Nath, West Chester, Ohio 45069 (US)
(74) Representative: Goode, Ian Roy

(57) **Abstract**

A vapor-coating system (20) is operable to coat a workpiece positioned therein. The vapor-coating system (20) includes a vapor-coating container (22) with a container wall (28). The container wall (28) has at least one inlet port (34) therethrough, with all inlet ports (34) having a total inlet port area, and at least one outlet port (36) therethrough, with all outlet ports (36) having a total outlet port area that is less than the total inlet port area. The system (20) further includes a source (40) of a sweeping gas (38) in communication with the at least one inlet port (34), and a source of a coating vapor (44) disposed to provide a coating vapor within the vapor-coating container (22).

## Description

This invention relates to a system for vapor coating of workpieces and, more particularly, to a system for controlling the chemical activity of a metallic coating vapor in such a coating system.

The operating environment within a gas turbine engine is both thermally and chemically hostile. Significant advances in high-temperature capabilities have been achieved through the development of iron-, nickel-, and cobalt-base superalloys and the use of oxidation-resistant environmental coatings capable of protecting superalloys from oxidation, hot corrosion, etc.

Diffusion aluminide coatings have particularly found widespread use for superalloy components of gas turbine engines. These coatings are generally formed by such methods as diffusing aluminum deposited by chemical vapor deposition (CVD), slurry coating, or by a diffusion process such as pack cementation, above-pack, or vapor (gas)-phase deposition.

Diffusion processes generally entail reacting the surface of a component with an aluminum-containing gas composition. In a case of particular interest, aluminum-containing source materials for vapor-phase deposition processes may be aluminum alloy particles or an aluminum halide. If the source material is an aluminum halide, a separate activator is not required. The source material is placed out of contact with the surface to be aluminided. Vapor phase aluminiding (VPA) is performed at a temperature at which the aluminum halide will react at the surface of the component to form a diffusion aluminide coating.

Although VPA processes are operable and are widely used, it is difficult to control the final thickness and the aluminum content as a function of position within the coating in VPA processes. One approach has been described in copending US Patent Application serial number 09/417,468, filed October 13, 1999. However, no apparatus for accomplishing the coating in a commercial setting was provided. There is accordingly a need for a vapor-coating system including an apparatus that provides these capabilities. The present invention fulfills this need, and further provides related advantages.

According to the invention, there is provided a vapor-coating system operable to coat a workpiece positioned therein comprises a vapor-coating container having a container wall, preferably made of graphite. The container wall has at least one inlet port therethrough, all inlet ports taken together having a total inlet port area, and at least one outlet port therethrough, all outlet ports taken together having a total outlet port area that is less than the total inlet port area. There is a source of a sweeping gas, preferably argon or hydrogen, in communication with the at least one inlet port, and a source of a coating vapor disposed to provide a coating vapor within the vapor-coating container. The source of the coating vapor preferably includes a halide of the metal to be deposited. The metal to be deposited is preferably aluminum or chromium, most preferably aluminum, but other metals such as hafnium and zirconium may be deposited as well by this approach. The source of the coating vapor may be external to the vapor-coating container, or within the vapor-coating container.

A ratio of the total outlet port area to the total inlet port area is less than 1.0, preferably is less than about 0.5, and most preferably is less than about 0.35. The source of the sweeping gas is desirably a variable-flow source of the sweeping gas.

The vapor-coating system is preferably used to coat only an external surface of the workpiece, and in that case the inlet ports and the outlet ports are not in contact registry with an interior of the workpiece.

In one embodiment, the vapor-coating container has a lower housing, and a lid that fits with the lower housing to form a closed container. The inlet and outlet ports are in the lid. In a particularly preferred version of this embodiment that has been tested, the volume of the container is from about 7000 cubic inches to about 8000 cubic inches, the total outlet port area is about 0.1 square inch, and the total inlet port area is about 0.3 square inches.

The present invention provides a vapor-coating system used to vapor coat a workpiece. The vapor-coating system allows the activity of the source of the coating vapor to be controlled so that the thickness of the coating and the composition of the coating as a function of position through the thickness of the coating may be controlled. The present approach may be practiced by modifying existing vapor-coating systems and procedures.

The vapor-coating system allows the activity of the aluminum-containing source vapor to be controllably varied by controlling the flow of the sweeping gas through the vapor-coating container. Other features and advantages of the present invention will be apparent from the following more detailed description of the preferred embodiments, taken in conjunction with the accompanying drawings, which illustrate, by way of example, the principles of the invention, and in which:
Figure 1 is a schematic depiction of a first embodiment of the vapor-coating system;
Figure 2 is a schematic depiction of a second embodiment of the vapor-coating system; and
Figure 3 is a block flow diagram of a preferred approach for coating a workpiece.

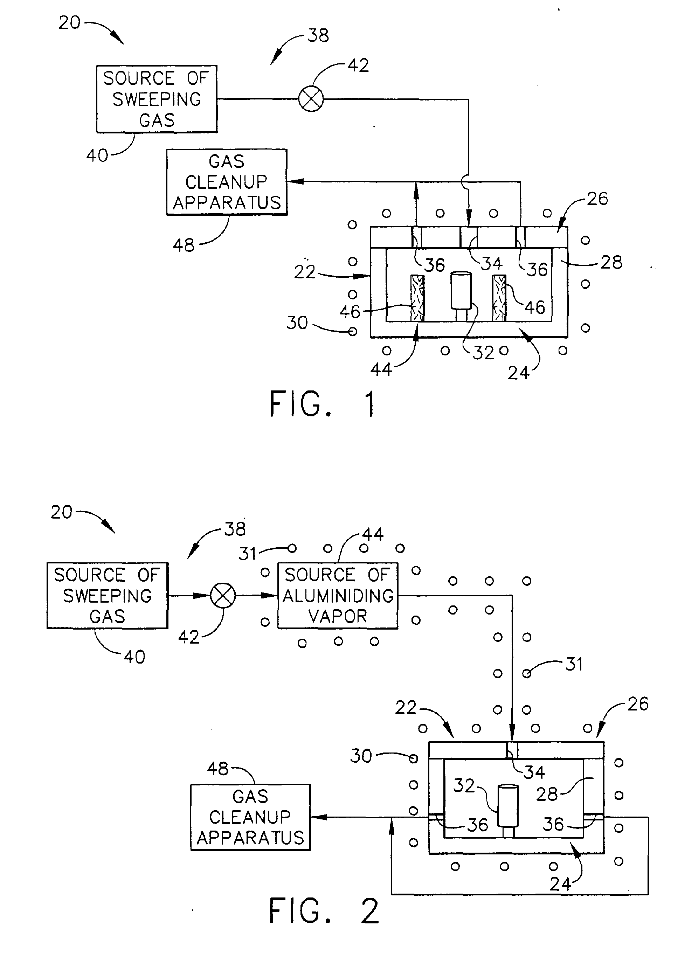

Figure 1 depicts a first, preferred embodiment of a vapor-coating system 20. The vapor-coating system 20 includes a vapor-coating container 22 having a lower housing 24, and a lid 26 that fits with the lower housing 24 to form a closed container. The lower housing 24 and the lid 26 together define a wall 28. The vapor-coating container 22 is of the construction discussed in US Patent 6,039,810, except as discussed herein. The wall 28, and specifically the lower housing 24 and the lid 26 are preferably made of graphite, as discussed in the '810 patent.

The vapor-coating container 22 is heated, typically by placing it into a furnace that is represented schematically by electrical resistance heating coils 30. A workpiece 32 to be coated, here illustrated as a turbine blade, is placed into the lower housing 24 and the lid 26 is sealed to the lower housing 24.

The wall 28 has at least one inlet port 34 therethrough, here illustrated as one inlet port 34. All of the inlet ports 34 taken together have a total inlet port area Aᵢ measured perpendicular to the gas flow through the inlet port 34. The wall 28 has at least one outlet port 36 therethrough, here illustrated as two outlet ports 36. All outlet ports 36 taken together have a total outlet port area Aₒ measured perpendicular to the gas flow through the outlet ports 36. The total outlet port area Aₒ is less than the total inlet port area Aᵢ. (That is, the ratio Aₒ/Aᵢ of the total outlet port area Aₒ to the total inlet port area Aᵢ must be less than 1.0.) The ratio Aₒ/Aᵢ is preferably less than about 0.5. Even more preferably, the ratio Aₒ/Aᵢ is less than about 0.35. Maintaining the ratio Aₒ/Aᵢ below 1 allows the flow of the sweeping gas to be controlled so that the residence of time of aluminum source vapor within the container 22 may be accurately controlled. The control is better if the ratio Aₒ/Aᵢ is less than about 0.5, and even better if the ratio Aₒ/Aᵢ is less than about 0.35. The constriction that defines the area Aₒ of the outlet port may be in the lid 26 of the vapor-coating container 22, as shown, or elsewhere.

The vapor-coating system 20 further includes a source of a sweeping gas 38 in gaseous flow communication with the at least one inlet port 34. The sweeping gas is preferably an inert gas such as argon or a reducing gas such as hydrogen. The source of the sweeping gas 38 includes a gas source 40 that may be of any operable type, such as a compressor, a gas bottle, or the like. The source of the sweeping gas 38 further includes a variable controller, here illustrated as a variable flow valve 42, by which the flow rate of the sweeping gas from the gas source 40 may be varied.

In a typical preferred case of the embodiment of Figure 1, wherein the volume of the vapor-coating container 22 is from about 7000 cubic inches to about 8000 cubic inches, the total outlet port area is about 0.1 square inch, and the total inlet port area is about 0.3 square inches. The flow rate of the sweeping gas is about 30 cubic feet per hour but is varied as desired to alter the activity of the coating vapor within the vapor-coating container 22.

A source of a coating vapor 44 is disposed to provide a coating vapor within the vapor-coating container 22. The source of the coating vapor preferably includes a metallic halide, such as a metallic fluoride, a metallic chloride, a metallic bromide, or a metallic iodide, that vaporizes at or below a coating temperature. The preferred source of the coating vapor 44 is a source of an aluminum-containing halide vapor or a source of a chromium-containing halide vapor, but sources of other metallic halide vapors such as a hafnium halide or a zirconium halide may be used. Mixtures of the vapor sources may be used to deposit, for example, such as an aluminum-containing halide and a chromium-containing halide. Such sources are known in the art in other applications. Examples include aluminum, chromium, hafnium and/or zirconium chloride, hafnium fluoride, etc. The coating of most interest is an aluminum coating, and the source of the coating vapor 44 is the source of the aluminum-containing vapor such as the aluminum halide vapor. The remainder of the discussion will be directed toward this case, with the understanding that it is applicable with appropriate modifications to other coating vapor sources.

Figure 1 illustrates an embodiment wherein the source of the aluminiding vapor 44 is within the vapor-coating container 22. The source of the aluminiding vapor 44 preferably includes an aluminum halide such as aluminum trichloride and, optionally, elemental aluminum. Both of these source materials are solid at room temperature. In the embodiment of Figure 1, the source materials are placed inside the vapor-coating container 22 in baskets 46 located within the lower housing 24. The workpiece, and typically in a production operation, workpieces 32 occupy the floor of the vapor-coating container 22. The inlet port(s) 34 and outlet port(s) 36 are therefore placed in the lid 26 for convenience.

Optionally, the gas flowing from the outlet port(s) 36 is passed to a gas cleanup apparatus 48, such as a gas scrubber.

Increasing the flow rate of the sweeping gas reduces the activity, and decreasing the flow rate of the sweeping gas increases the activity, of the aluminiding vapor by correspondingly decreasing or increasing its residence time in the vapor-coating container 22. The thickness of the coating that is deposited in a set period of time may be increased by increasing the activity and residence time of the vapor through a decrease in the flow rate of the sweeping gas. The amount of aluminum deposited into the coating as a function of time may also be varied, so that the distribution of aluminum through the thickness of the coating may be varied as a function of time and the position in the thickness of the coating.

Figure 2 illustrates a second embodiment of the vapor-coating system 20, which is operable but less preferred than the embodiment of Figure 1. The vapor-coating system 20 of Figure 2 is similar to that of Figure 1, except as will be discussed next, and the above-assigned reference numerals and the above discussion are otherwise incorporated for the embodiment of Figure 2.

The embodiment of Figure 2 differs from that of Figure 1 in that the source of the aluminiding vapor 44 is external to the vapor-coating container 22. The source of the aluminiding vapor 44 that is used in this case is heated to vaporize the aluminum halide and the gas would be kept heated before it reached the vapor-coating container 22 as well as when it was in the vapor-coating container 22, as for example by using heating coils 31. The sweeping gas from the source of the sweeping gas 38 passes through the source of the aluminiding vapor 44 prior to entering the vapor-coating container 22 and carries the vapor into the vapor-coating container 22. The embodiment of Figure 2 may be conveniently implemented by placing both the source of the aluminiding vapor 44 and the vapor-coating container 22 into a single large furnace with a vapor-flow conduit extending between them.

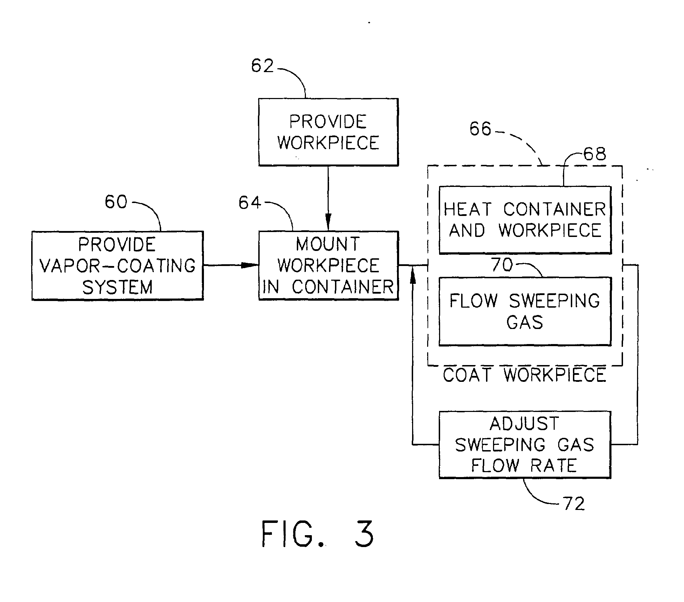

Figure 3 illustrates a preferred approach for practicing the invention. A vapor-coating system, preferably like that shown in Figures 1 or 2, is provided, numeral 60. A workpiece is provided, numeral 62. The workpiece, preferably a component of a gas turbine engine such as a turbine blade or turbine vane, is prepared separately, and its preparation is not a part of the present invention. The workpiece is preferably made of an iron-base, a nickel-base, or a cobalt-base superalloy. The workpiece is mounted in the vapor-coating container 22, numeral 64. The workpiece is then coated, numeral 66. The coating step 66 generally involves two concurrently conducted steps. One step is a heating of the container, the workpiece, and the source of the aluminiding vapor 44 to a coating temperature, numeral 68. The coating temperature is at least about 1800°F, preferably from about 1800°F to about 2000°F, and most preferably from about 1875°F to about 1975°F. While the container, workpiece, and source of the aluminiding vapor 44 are at the coating temperature, the sweeping gas is flowed through the vapor-coating container 22, numeral 70. The activity of the aluminiding vapor is thereby controlled in the manner discussed earlier. If desired, the flow rate of the sweeping gas may be adjusted, numeral 72, during the coating to vary the coating rate and also to vary the concentration of aluminum as a function of depth from the surface of the coating.

The present invention has been reduced to practice using the apparatus illustrated in Figure 1 and the procedure of Figure 3. The cylindrical vapor-coating container 22, made of graphite, was 32 inches in internal diameter and 9.8 inches in internal height. The inlet port was 5/8 inches in diameter in the center of the lid. There were two outlet ports, each 1/4 inch in diameter, and positioned on a diameter of the lid on either side of the center and 9 inches from the center. The flow rate of the sweeping gas was about 30 cubic feet per hour. In various tests, an aluminide coating about 0.001 to about 0.004 inches in thickness was deposited at a temperature of about 1975°F in about 4-7 hours.

## Claims

1. A vapor-coating system (20) operable to coat a workpiece positioned therein, the vapor-coating system (20) comprising
a vapor-coating container (22) having a container wall (28), the container wall (28) having
at least one inlet port (34) therethrough, all inlet ports (34) taken together having a total inlet port area, and
at least one outlet port (36) therethrough, all outlet ports (36) taken together having a total outlet port area that is less than the total inlet port area;
a source of a sweeping gas (38) in communication with the at least one inlet port (34); and
a source of a coating vapor (44) disposed to provide a coating vapor within the vapor-coating container (22).

2. The vapor-coating system (20) of claim 1, wherein the container wall (28) is made of graphite.

3. The vapor-coating system (20) of claim 1 or claim 2, wherein the source of the sweeping gas (38) comprises a source of a gas selected from the group consisting of argon and hydrogen.

4. The vapor-coating system (20) of any one of claims 1 to 3, wherein the source of the coating vapor (44) is external to the vapor-coating container (22).

5. The vapor-coating system (20) of any one of claims 1 to 3, wherein the source of the coating vapor (44) is within the vapor-coating container (22).

6. The vapor-coating system (20) of any one of claims 1 to 5 wherein a ratio of the total outlet port area to the total inlet port area is less than about 0.5.

7. The vapor-coating system (20) of any one of claims 1 to 6, wherein the source of the sweeping gas (38) is a variable-flow source of the sweeping gas (38).

8. The vapor coating system (20) of any one of claims 1 to 7, wherein the source of the coating vapor (44) is a source of an aluminiding vapor, or is a source of a chromiding vapor.

9. The vapor-coating system (20) of any one of claims 1 to 8 wherein the source of the coating vapor (44) is a source of a metal-halide coating vapor.

10. The vapor-coating system (20) of claim 9, wherein the source of the coating vapor (44) is selected from the group consisting of an aluminum halide vapor source, a chromium halide vapor source, a hafnium halide vapor source, and a zirconium halide vapor source.

11. A vapor-coating system (20) of any one of claims 1 to 10 wherein the a vapor-coating container (22) comprises
a lower housing (24), and
a lid (26) that fits with the lower housing (24) to form a closed container (22), the lid (26) having therein the at least one inlet port (34) and the at least one outlet port (36).
